Europäisches Patentamt

European Patent Office

Office européen des brevets

(11) Veröffentlichungsnummer: **0 066 789**
**B1**

(12) **EUROPÄISCHE PATENTSCHRIFT**

(45) Veröffentlichungstag der Patentschrift:
14.11.84

(51) Int. Cl.³: **G 03 F 9/00**, G 03 B 27/50

(21) Anmeldenummer: **82104618.2**

(22) Anmeldetag: **27.05.82**

(54) **Einzugs- und Transportvorrichtung für Druckformen.**

(30) Priorität: **05.06.81 DE 3122321**

(43) Veröffentlichungstag der Anmeldung:
**15.12.82 Patentblatt 82/50**

(45) Bekanntmachung des Hinweises auf die Patenterteilung:
**14.11.84 Patentblatt 84/46**

(84) Benannte Vertragsstaaten:
**BE DE FR GB IT NL**

(56) Entgegenhaltungen:
**EP - A - 0 037 065**
**DE - A - 2 462 216**
**DE - A - 2 844 528**
**FR - A - 1 163 747**
**GB - A - 27 358**
**US - A - 2 681 618**

(73) Patentinhaber: **HOECHST AKTIENGESELLSCHAFT,**
**Postfach 80 03 20, D-6230 Frankfurt am Main 80 (DE)**

(72) Erfinder: **Back, Günter, Rosenstrasse 33,**
**D-6238 Hofheim 3 (DE)**

ACTORUM AG

## Beschreibung

Die Erfindung betrifft eine Einzugs- und Transportvorrichtung für Druckformen, die auf einen Belichtungstisch mit Hilfe von Rollen transportierbar sind, mit zu beiden Seitenkanten der Druckform angeordneten Rollen, von denen die in Transportrichtung der Druckformen zuerst liegenden Rollen nach aussen schwenkbar sind.

Die Herstellung von beschrifteten und bebilderten Druckformen, beispielsweise Druckplatten, die unmittelbar zum Drucken geeignet sind, geschieht in der Weise, dass die Druckplatten zuerst elektrostatisch aufgeladen und anschliessend eine Vorlage bildmässig auf die einzelne Druckplatte projiziert wird. Nach Beendigung dieses Belichtungsvorgangs wird die Druckplatte mit einem Entwickler entwickelt, fixiert und entschichtet, wonach sie fertig für den Druckvorgang ist.

Aus der DE-PS Nr. 2462216 ist ein Gerät zur elektrophotographischen Herstellung von Druckformen bekannt, bei dem die einzelne Druckform von einem Stapel in einem Plattenmagazin durch eine Transportvorrichtung abgehoben wird, die aus einem Transportwagen mit einer Unterdrucksaugeinrichtung besteht und welche die Druckformen zu einer Belichtungsbühne transportiert. Um das Aufladen der einzelnen Druckform zeitsparend mit deren Transport zu der Belichtungsbühne zu verbinden, ist eine Koronaaufladestation für die elektrostatische Aufladung der Druckplatten an der Vorderseite des Transportwagens angeordnet und erstreckt sich quer zur Bewegungsrichtung des Transportwagens. Der Transportwagen läuft über zwei Führungsschienen und ist von einem auf der Oberseite angeordneten Motor antreibbar, der über ein Zahnrad mit einem Zahnstangentrieb im Eingriff steht, der parallel zu der Bewegungsrichtung des Transportwagens angeordnet ist. Dieser weist an der Unterseite eine Vakuumplatte auf, die über eine Anzahl von Löchern mit einer Vakuumpumpe in Verbindung steht. Beim Aufsetzen der Vakuumplatte des Transportwagens auf die Oberseite der obersten Druckplatte im Plattenmagazin wird ein Unterdruck erzeugt, durch den diese Druckplatte an die Vakuumplatte angesaugt wird. Danach wird der Transportwagen mit Hilfe des Motors in Richtung der Belichtungsbühne gefahren, wo er, sobald er seine Position oberhalb der Belichtungsbühne erreicht hat, auf diese abgesenkt wird und das Vakuum der Vakuumplatte aufgehoben wird, so dass die Druckplatte freigegeben und auf die Belichtungsbühne abgesetzt wird. Diese enthält gleichfalls eine Vakuumplatte, die mit Unterdruck beaufschlagt wird, so dass die Druckplatte während des Belichtungsvorgangs fest gegen die Belichtungsbühne gepresst ist.

Bei diesem bekannten Gerät wird beim Abheben der einzelnen Druckplatte vom Stapel die fotoleiterbeschichtete Seite der Druckplatte mit Saugeinrichtungen berührt, die zwar einen wesentlich schonenderen Transport der Druckplatte im Vergleich zu Rollen oder Bändern, die über die beschichtete Seite der Druckplatte geführt sind, bei anderen bekannten Geräten ermöglichen, jedoch können mechanische oder physikalische Fehlstellen auf der fertig entwickelten Druckplatte, verursacht durch die Saugeinrichtungen, nicht völlig ausgeschlossen werden.

Aus der veröffentlichten europäischen Patentanmeldung Nr. 0000048 ist eine Transportstation für Druckplatten bekanntgeworden, die einen Stapelbereich aufweist, in dem sich ein Vorrat an Druckplatten befindet, die jeweils mit Papierblättern abgedeckt sind. Für die zwischen zwei Platten vorhandenen Papierblätter ist eine Papierablage vorgesehen. Die Druckplatten werden durch einen Steuerungsmechanismus, der eine Anzahl von Saugnäpfen aufweist, vom Stapelbereich zu einem Förderband transportiert. Der Steuerungsmechanismus ist schwenkbar an einer Führungsstange befestigt, die über ein Getriebe mit einem Motor verbunden ist, um eine seitliche Gleitbewegung vor und zurück ausführen zu können. Die oberste Druckplatte wird von zumindest vier Saugnäpfen des Steuerungsmechanismus angesaugt, daran anschliessend schwenkt der Steuerungsmechanismus nach vorn und gleichzeitig wird die Führungsstange mechanisch auf das Förderband hin bewegt. Wird das Vakuum in den Saugnäpfen aufgehoben, so senkt sich der Steuerungsmechanismus nach unten ab und legt die Druckplatte auf dem Förderband ab. Ein zweiter Steuerungsmechanismus oberhalb des Papierblattes ergreift dieses, hebt es ab und befördert es zu der Papierablage.

Das Förderband transportiert die Druckplatte auf eine Belichtungsbühne, die eine Anzahl von Löchern in ihrer Oberfläche enthält und eine Kammer bildet, die über eine Saugleitung mit einer Vakuumpumpe verbunden ist. Die Druckplatte wird, nachdem sie in die richtige Position auf der Oberfläche der Belichtungsbühne gebracht wurde, durch Erzeugung eines Vakuums auf dieser festgehalten. Mit Hilfe eines Belichtungssystems erfolgt die Belichtung der Druckplatte.

Ebenso wie im zuvor erwähnten Stand der Technik erfolgt das Abheben der obersten Druckplatte vom Stapel in der Weise, dass die fotoleitfähige Schicht der Druckplatte mit Saugeinrichtungen berührt wird, was zu mechanischen oder physikalischen Fehlstellen auf der fertigen Druckplatte führen kann.

Um die fotoleitfähige Schicht der Druckplatte während des Transports von einem Plattenmagazin zu einem Belichtungstisch mechanisch nicht zu berühren, wird in der deutschen Patentanmeldung P Nr. 3012815.5 (EP-A Nr. 37064) vorgeschlagen, einen schwenkbaren Hubzylinder mit einer aus dem Hubzylinder aus- und in diese einfahrbaren Kolbenstange auszurüsten, die eine schüsselförmige Platte für das Ansaugen und Absetzen der obersten Druckplatte des Stapels trägt, und den Hubzylinder um einen Drehpunkt zwischen einer Aufnahme- und einer Absetzposition der Druckplatte zu verschwenken.

In der deutschen Patentanmeldung P Nr. 3012761.8 (EP-A Nr. 37065) wird die Aufgabe gelöst, eine kreisbogenförmig von oben auf eine Auflagefläche abgesenkte Druckplatte, deren fotoleitfähig beschichtete Seite nach oben gerichtet ist, an eine mit Rollen ausgerüstete Vorrichtung für den Weitertransport zu übergeben, ohne dass die Druckplatte beim Absenken auf die Rollen zu liegen kommt und ohne dass die fotoleitfähige Schicht der Druckplatte mit den Rollen in Berührung gelangt.

Als Lösung wird vorgeschlagen, dass ein schwenkbarer Hubzylinder die Druckform in Gestalt einer Druckplatte einem Magazin entnimmt und kreisbogenförmig mit dem Vorderteil auf eine Saugplatte des Belichtungstisches auflegt, dass parallel zu beiden Seitenkanten der Druckplatte in der Transportrichtung je eine Reihe von Transport- und Antriebsrollen angeordnet ist, und dass die in der Transportrichtung der Druckplatte zuerst liegenden Transportrollen aus den Reihen nach aussen schwenkbar sind, um ein klemmfreies Ablegen des Vorderteils der Druckplatten auf die Saugplatte des Belichtungstisches zu ermöglichen. Nach der Ablage der Druckplatte auf dem Belichtungstisch liegen die beiden, zueinander parallelen Rollenleisten mit den Transport- und Antriebsrollen an den Seitenkanten der Druckplatte an und zentrieren diese während der Belichtung. Da die Rollen eine bestimmte Rillentiefe besitzen, stehen sie am Rand bzw. an den Seitenkanten der Druckplatte in deren Inneres um diese Rillentiefe über, so dass eine Belichtung der Druckplatte bis zum Rand hin ausgeschlossen ist.

Aufgabe der Erfindung ist es, eine Vorrichtung der eingangs beschriebenen Art so zu verbessern, dass eine Belichtung über die gesamte Breite bis zu den Aussenkanten einer Druckform möglich ist.

Diese Aufgabe wird erfindungsgemäss dadurch gelöst, dass die Rollen drehbar auf Blöcken gelagert sind, die auf zwei zueinander parallelen und beweglichen Rollenleisten befestigt sind, und dass Mittel vorgesehen sind, um vor der Belichtung die Rollenleisten senkrecht zu den Seitenkanten der Druckform nach aussen hin in eine Position parallel zu den Seitenkanten zu verschieben.

Die weitere Ausgestaltung der Erfindung ergibt sich aus den Merkmalen der Ansprüche 2 bis 12.

Mit der Erfindung wird der Vorteil erzielt, dass Druckformen unterschiedlicher Breite bis zum Rand hin belichtet werden können, so dass eine optimale Materialausnutzung erfolgt und darüber hinaus auch von grossformatigen Vorlagen Druckformen hergestellt werden können, die sich aus zwei oder mehreren Druckformen gängiger Formate zusammensetzen, die ohne störenden Rand nach erfolgter Belichtung der einzelnen Druckformen für den Druckvorgang zusammengefügt werden können.

Die Erfindung wird im folgenden anhand eines in den Zeichnungen dargestellten Ausführungsbeispiels näher beschrieben. Es zeigen:

Fig. 1 eine schematische Darstellung verschiedener Bearbeitungsstationen einer Vorrichtung zur Abbildung einer Vorlage auf der fotoleitenden Oberfläche einer Druckform,

Fig. 2 eine perspektivische Teilansicht des Belichtungstisches mit den am Rand der Druckform anliegenden Rollenleisten und im Abstand d vom Rand der Druckform entfernten Rollenleisten,

Fig. 3 eine Draufsicht auf den Verstellmechanismus der Rollenleisten bei abgenommener Saugplatte des Belichtungstisches, und

Fig. 4 eine Draufsicht auf einen Teil des Verstellmechanismus nach Fig. 3.

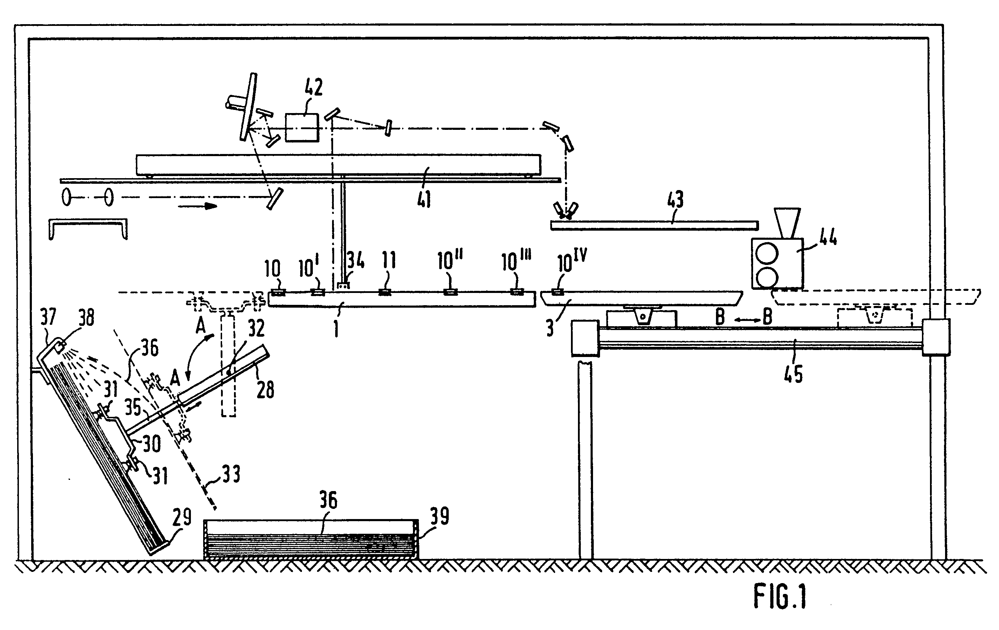

Verschiedene Bearbeitungsstationen einer Vorrichtung zur Abbildung einer Vorlage auf der Oberfläche einer Druckform sind in Fig. 1 schematisch dargestellt. Als Druckform wird eine Druckplatte bevorzugt, die aus einem Metallträger besteht, beschichtet mit einer fotoleitfähigen Schicht. Als Druckform können ebenso fotoleitfähige beschichtete Papiere, Kunststoffolien u. dgl. Material verwendet werden. In der Beschreibung wird weiterhin nur auf Druckplatten Bezug genommen, jedoch sind deswegen andere Druckformen nicht ausgeschlossen.

Eine Transportstation für Druckplatten 33, die in einem Magazin 29 gespeichert sind, umfasst einen schwenkbaren Hubzylinder 28 mit einer aus dem Hubzylinder aus- und in diesen einfahrbaren Kolbenstange 35. Die Druckplatten 33 sind in dem Magazin 29 in der Weise gestapelt, dass jede einzelne Druckplatte innerhalb des Stapels mit ihrer fotoleitfähigen beschichteten Seite nach unten zu liegen kommt.

Die Kolbenstange 35 trägt an dem aus dem Hubzylinder 28 herausragenden Ende eine schüsselförmige Platte 30, an der mehrere Saugelemente 31 befestigt sind. Die Saugelemente 31 sind von Federn umgeben, die zwischen der Innenseite der Platte 30 und den Saugnäpfen der Saugelemente 31 angeordnet sind.

Der Hubzylinder 28 ist um einen Drehpunkt 32 aus einer Schräglage in eine vertikale Lage verschwenkbar, wie diese durch den Doppelpfeil A-A angezeigt ist. In seiner Aufnahmeposition ist der Hubzylinder 28 so um den Drehpunkt 32 schwenkbar, dass er senkrecht auf die unbeschichtete Seite der obersten Druckplatte gerichtet ist. Sobald die Saugelemente 31 durch Ausfahren der Kolbenstange 35 auf die oberste Druckplatte aufgesetzt sind, werden sie mit Unterdruck beaufschlagt und die Kolbenstange 35 in den Hubzylinder zum Teil eingefahren, bis die von den Saugelementen angesaugte Druckplatte 33 die in der Zeichnung gestrichelt dargestellte Lage einnimmt.

Am oberen Ende des Magazins 29 ist an einem abgewinkelten Trägerarm 37 eine Luftdüse 38 vorgesehen, von der ein Luftstrom nahezu tangential auf die Unterseite der vom Stapel abgehobenen Druckplatte 33 gerichtet ist. Der gegen die vom Stapel abgehobene Druckplatte 33 gerichtete Luftstrom aus der Luftdüse 38 löst ein Abdeckblatt 36 aus Papier, Kunststoff, Folie od. dgl. ab, das die beschichtete Seite der Druckplatte gegen Beschädigungen schützt. Das Blatt 36 wird von dem Luftstrom in eine unterhalb des Belichtungstisches 1 angeordnete Auffangwanne 39 geblasen.

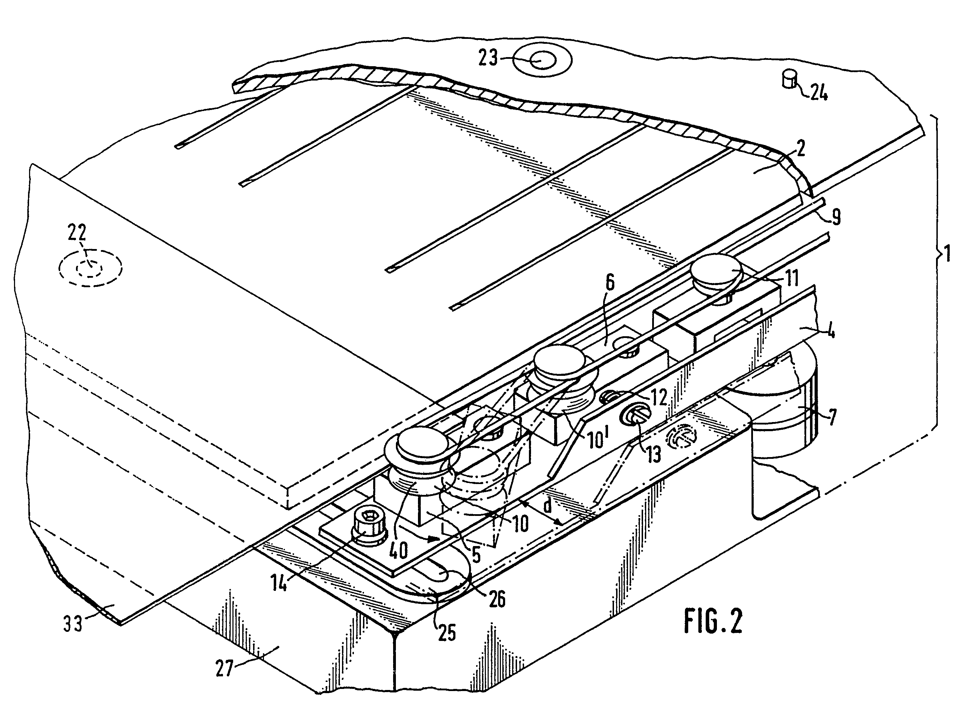

Anschliessend wird der Hubzylinder 28 um den Drehpunkt 32 in seine Vertikalstellung geschwenkt, so dass die Druckplatte 33 eine kreisbogenförmige Schwenkbewegung ausführt und von oben her mit ihrem Vorderteil, wie dies Fig. 2 zeigt, auf die Saugplatte 2 des Belichtungstisches 1 aufgesetzt wird.

Zu beiden Seiten des Belichtungstisches befindet sich je eine Reihe von Rollen. Die beiden ersten, in einer Reihe hintereinander liegenden Rollen sind Transportrollen 10, 10', die dann folgende Rolle ist eine Antriebsrolle 11, und daran schliessen sich wieder Transportrollen 10'', 10''', 10$^{IV}$ an, wie in der schematischen Ansicht in Fig. 1 gezeigt ist.

In Fig. 2 ist jeweils nur eine Reihe der Transport- und Antriebsrollen aus Gründen der besseren Übersichtlichkeit gezeigt. Es versteht sich von selbst, dass die nicht gezeigte Reihe der Rollen analog zu der dargestellten Reihe aufgebaut ist.

Der Belichtungstisch 1 umfasst die Saugplatte 2, auf welche die Druckplatte 33 durch den Hubzylinder 28 so aufgelegt wird, dass ihre Vorderkante zwischen der ersten Transportrolle 10 und der zweiten Transportrolle 10' zu liegen kommt. Wie voranstehend schon erwähnt wurde, sind die Transportrollen ebenso wie die Antriebsrollen paarweise zu beiden Seiten der Saugplatte 2 angeordnet. Wenn in der Beschreibung von einer Transportrolle bzw. einer Antriebsrolle die Rede ist, so steht diese stellvertretend jeweils für ein Paar Rollen. Die Transportrollen 10, 10', 10'', ..., und die Antriebsrolle 11 einer Reihe sind drehbar auf Rollenblöcken gelagert, die auf einer Rollenleiste 4 bzw. 4' befestigt sind. Von diesen Rollenblöcken sind diejenigen, die in der Transportrichtung zuerst liegen, als Schwenkblöcke 5 ausgebildet, während die übrigen Rollenblöcke 6 nicht schwenkbar, sondern nur seitlich verschiebbar und/oder ortsfest angeordnet sind. In Fig. 2 ist die Anordnung der Transportrollen gestrichelt eingezeichnet, bei der die in der Transportrichtung der Druckplatte 33 zuerst liegenden Transportrollen 10 aus jeder der beiden Reihen von Transportrollen nach aussen geschwenkt sind, um ein klemmfreies Ablegen des Vorderteils der Druckplatte 33 auf die Saugplatte 2 des Belichtungstisches 1 zu ermöglichen. Die beigeschwenkte Lage der Transportrolle 10 ist in Fig. 2 mit durchgehenden Linien dargestellt.

Beim Auflegen der Druckplatte 33 wird über einen vorderen Signalgeber 22, das ist ein Schalter oder ein Näherungsinitiator, ein nicht dargestellter Hubmagnet angesteuert und geschaltet, der unterhalb der Saugplatte 2 bzw. unterhalb des Belichtungstisches 1 befestigt ist und der über ein gleichfalls nicht dargestelltes Hebelgestänge mit den Schwenkblöcken 5 verbunden ist.

Jede Transportrolle 10, 10', 10'', ..., weist eine Rille 40 auf, in der die Seitenkanten der Druckplatte 33 während des Transports geführt sind. Sobald die Schwenkblöcke 5 an die Druckplatte 33 herangeschwenkt sind, erfassen die umlaufenden Transportrollen 10 die Druckplatte 33 und fördern sie zur Gänze auf die Saugplatte 2 des Belichtungstisches 1. Der Antrieb der Transportrollen erfolgt über je eine Antriebsrolle 11 in jeder Reihe der transportrollen, und zwar mit Hilfe eines Antriebsmotors 7, der an der Rollenleiste 4 bzw. 4' befestigt ist und die Antriebsrolle 11 antreibt. Die beiden Antriebsmotoren 7 in den beiden Reihen von Rollen sind als Synchronmotoren ausgebildet, so dass ein ständiger Gleichlauf dieser Antriebsmotoren bzw. der Antriebsrollen gewährleistet ist. Von jeder Antriebsrolle 11 führen Rundschnurtransportringe 9 zu den benachbarten Transportrollen 10', 10''. Die Transportrolle 10'' ist gleichfalls durch einen Rundschnurtransportring 9 mit der nachfolgenden Rolle 10''' verbunden, während die Transportrolle 10' mit der ersten Transportrolle 10 auf dem Schwenkblock 5 über einen Rundschnurtransportring 9 in Verbindung steht.

Die Rollenblöcke 6 der Transportrollen 10', 10'', 10''', ..., sind mit Stellschrauben 13, die durch den vertikalen Schenkel der Rollenleiste 4 hindurchgeführt sind und mit den zugehörigen Rollenblöcken 6 im Eingriff stehen, quer zur Transportrichtung der Druckplatte 33 verschiebbar. Dabei ist die Stellschraube 13 von einer Druckfeder 12 umgeben, die an der Innenwand des vertikalen Schenkels der Rollenleiste 4 und am Rollenblock 6 anliegt. Dadurch ist sichergestellt, dass beim Transport die einzelnen Rollenblöcke 6 durch die Druckfeder 12 seitlich nachgeben können, so dass auch geringfügige Versetzungen oder Schräglagen der Druckplatte 33 während des Transports durch die elastische Lagerung der Rollenblöcke ausgeglichen werden können. Entweder können alle Rollenblöcke 6 der beiden Reihen von Transportrollen mit Stellschrauben 13 ausgerüstet sein oder nur eine der Reihen, während die andere Reihe von Transportrollen ortsfest auf der Rollenleiste befestigt ist.

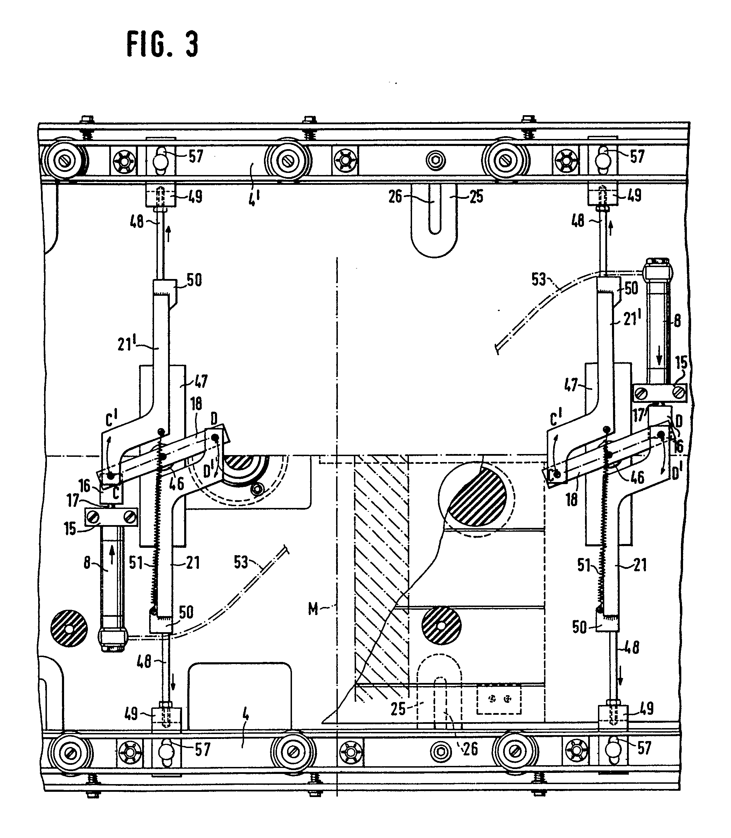

Die Druckplatte 33 wird so lange auf der Saugplatte 2 vorwärtstransportiert, bis sie gegen einen Anschlag 24 anliegt, der in der Saugplatte 2 versenkbar ist. Während des Transports der Druckplatte 33 ist selbstverständlich die erste Transportrolle 10 beigeschwenkt und liegt gegen die Seitenkante der Druckplatte 33 an. Sobald die Druckplatte durch den Anschlag 24 positioniert ist, wird die Saugplatte 2 mit Unterdruck beaufschlagt, so dass die Druckplatte 33 in ihrer Belichtungslage festgehalten wird. Zugleich mit der Positionierung der Druckplatte 33 durch den Anschlag 24 wird ein Signalgeber 23, beispielsweise ein Schalter oder Näherungsinitiator, in der Ebene des Belichtungstisches 1 durch die Vorderkante der Druckplatte 33 betätigt. Der Signalgeber 23 steuert zumindest zwei Hubzylinder 8, die unterhalb der Saugplatte 2 des Belichtungstisches 1 angeordnet sind und die jeweils über ein Drehgestänge 16, 18, 21, 21', 48, 50 (Fig. 3) mit jeder der Rollenleisten 4, 4' verbunden sind. Wie im einzelnen noch näher erläutert werden wird, verdrehen die Hubzylinder die Drehgestänge kreisbogenförmig, die ihrerseits die Rollenleisten 4, 4' senkrecht zu den Seitenkanten der Druckplatte 33 nach aussen hin in eine Position parallel zu den Seitenkannten verschieben. Dadurch sind die Rollenleisten 4, 4' um einen Abstand d bis etwa 15 mm von den Seitenkanten weggeschwenkt, so dass eine Belichtung bis zu den Aussenkanten der Druckplatte 33 möglich ist.

Wie in Fig. 1 gezeigt ist, befindet sich oberhalb des Belichtungstisches 1 ein horizontal verfahrbarer Belichtungswagen 41, der optische Elemente 42 zum Abtasten einer Vorlage 43 und zum Belichten der Druckplatte 33 trägt. Da es sich bei diesen Bearbeitungsstationen um bekannte Einrichtungen handelt, werden sie nicht näher beschrieben.

An der Unterseite des Belichtungswagens 41 ist eine Koronavorrichtung 34 befestigt, die beim horizontalen Verfahren des Belichtungswagens 41 die Druckplatte 33 auflädt, die anschliessend belichtet wird. Nachdem die Druckplatte 33 belichtet ist, wird der Anschlag 24 versenkt, die Rollenleisten 4, 4' an die Seitenkanten der Druckplatte 33 angeschwenkt und diese durch die Transportrollen 10, 10', 10'', ..., auf einen Entwicklungstisch 3 weitertransportiert, der mit einer darunter angeordneten Antriebswelle 45 verbunden ist, längs der er in Richtung des Doppelpfeils B-B hin- und herverschoben werden kann. Oberhalb des Entwicklungstisches 3 befindet sich eine Entwicklungsvorrichtung 44, die von oben her über eine Magnetbürste an die Oberfläche der Druckplatte 33 einen Entwicklerbelag, bestehend aus einer Mischung von Trägerteilen und Toner, anträgt, während die Druckplatte 33 unterhalb der Entwicklungsvorrichtung 44 vorbeigeführt wird.

Während des Weitertransports der Druckplatte 33 ist der Niederdruck der Saugplatte 2 aufgehoben. Sobald die Hinterkante der Druckplatte 33 den Signalgeber 23 freigibt, wird von diesem der nicht dargestellte Verstellmechanismus für die erste Transportrolle 10 angesteuert und erregt, so dass die Schwenkblöcke der ersten Transportrollen 10 in die Öffnungslage ausschwenken. In dieser Stellung ist es dann möglich, eine neue Druckplatte 33 ohne Schwierigkeiten zuzuführen, durch die Rillen der Transportrollen zu erfassen und anschliessend weiterzutransportieren.

Auf der Oberseite eines Saugplattenträgers 27 des Belichtungstisches 1 sind zwei Führungsteile vorgesehen, von denen in Fig. 2 nur das vordere Führungsteil 25 dargestellt ist, das quer zur Transportrichtung der Druckplatte 33 angeordnet ist.

Das zweite, nicht gezeigte Führungsteil verläuft parallel zu dem ersten Führungsteil nahe der hinteren Kante des Saugplattenträgers 27. Jedes Führungsteil weist einen Schlitz 26 auf. Die Rollenleisten 4, 4' liegen auf den Führungsteilen 25 auf und sind am vorderen und am hinteren Ende von je einem Führungsstift 14 durchsetzt, der mit den Schlitzen 26 in den Führungsteilen 25 in Eingriff steht. Dadurch ist es möglich, die Rollenleisten 4, 4' quer zu der Transportrichtung der Druckplatte 33, entlang den Führungsteilen 25, zu verschieben.

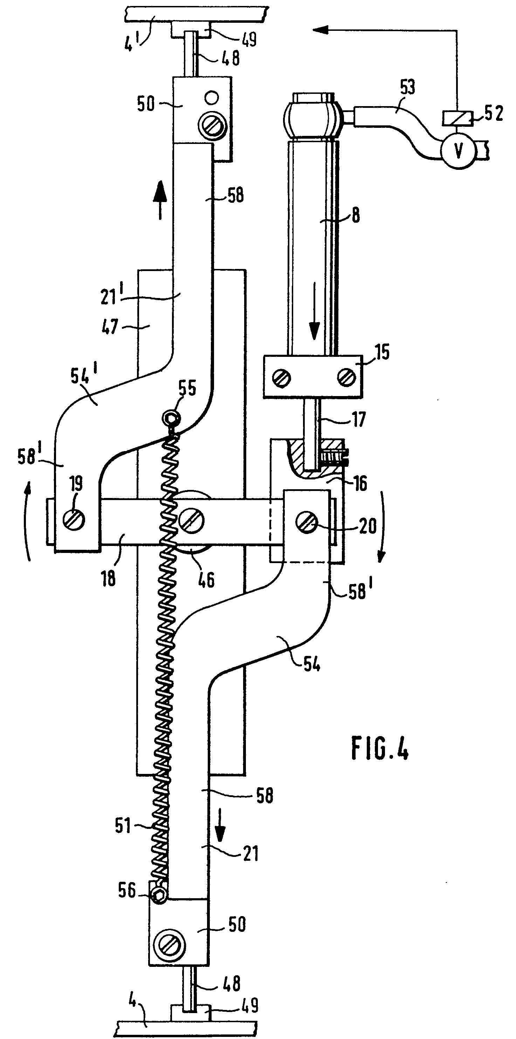

Im folgenden wird anhand der Fig. 3 und 4 der Verstellmechanismus für die Rollenleisten 4, 4' und seine Anordnung unterhalb der Saugplatte 2 auf dem Saugplattenträger 27 des Belichtungstisches 1 beschrieben. In den Draufsichten der Fig. 3 und 4 ist die Saugplatte von dem Belichtungstisch 1 abgenommen.

Auf dem feststehenden Saugplattenträger 27, beispielsweise einem Gussteil, sind zwei Hubzylinder 8 in einer Halterung 15 montiert. Durch ein Anschlussstück 16 ist eine Kolbenstange 17 des Hubzylinders drehbar mit einer Schwenklasche 18 verbunden. Diese Schwenklasche 18 weist zwei Anlenkpunkte 19, 20 auf, an denen Schwenkhebel 21, 21' mit dem einen Ende drehbar angelenkt sind. Die Schwenklasche 18 ist geradlinig ausgebildet und mittig in einer Zentralhülse 46 geführt, die auf einer Zentralbefestigung 47 montiert ist. Das andere Ende jedes Schwenkhebels 21, 21' ist an einem zugehörigen Klemmstück 50 befestigt. Von den Klemmstücken 50 führen Stangen 48 über Verbindungslaschen 49 zu den Rollenleisten 4, 4'. Die Stangen 48 können innerhalb der Klemmstücke 50 um einen bestimmten Betrag verschoben werden, so dass der Abstand der Rollenleisten 4, 4' voneinander auf Druckplattenbreiten im Bereich von 300 bis 500 mm einstellbar ist.

Jedes Drehgestänge, das mit einem Hubzylinder 8 verbunden ist, besteht aus dem Anschlussstück 16, das mit der Kolbenstange 17 des Hubzylinders 8 verbunden ist, des weiteren der Schwenklasche 18 mit den zwei Anlenkpunkten 19, 20, den beiden Schwenkhebeln 21, 21' mit den zugehörigen Klemmstücken 50 sowie den Stangen 48, die über die Verbindungslaschen 49 mit den Rollenleisten 4, 4' in Verbindung stehen. Jeder Schwenkhebel 21, 21' weist zwei parallele, zueinander um die Länge eines Verbindungsstückes 54 bzw. 54' versetzte geradlinige Stücke 58, 58' auf. Das Verbindungsstück 54 bzw. 54' schliesst bogenförmig an die geradlinigen Stücke 58, 58' an. Eine Rückstellfeder 51 bringt die Rollenleiste 4, 4' in ihre Ausgangsstellung zurück und ist mit dem einen Ende an einem Befestigungspunkt 55 auf dem einen Schwenkhebel 21' und mit dem anderen Ende an einem weiteren Befestigungspunkt 56 auf dem Klemmstück 50 des anderen Schwenkhebels 21 befestigt. In der Ruhestellung des Verstellmechanismus liegen die Rollenleisten 4, 4' an den Seitenkanten der Druckplatte 33 an. Wie zuvor beschrieben wurde, wird die Druckplatte 33 mittels der in Ruhestellung befindlichen Rollenleisten 4, 4' auf die Saugplatte 2 des Belichtungstisches 1 bis zum Anschlag 24 transportiert und in dieser Stellung angesaugt. Die beiden Hubzylinder 8 sind über eine Druckleitung 53 miteinander verbunden, in der ein Magnetventil 52 angeordnet ist. Die Druckbeaufschlagung der beiden Hubzylinder 8 wird durch das Magnetventil 52 gesteuert, das durch Signale von dem Signalgeber 23 ausgelöst wird. Sobald die beiden Hubzylinder 8 mit Druckluft beaufschlagt sind, bewegen sich die Kolbenstangen 17, wodurch die Schwenklaschen 18 um die Zentralhülsen 46 verschwenkt werden. Wie aus Fig. 3 ersichtlich ist, werden dann die Anlenkpunkte 19, 20 der Schwenklaschen 18 aus ihren Positionen C und D in die Positionen C' und D' bzw. in die umgekehrte Richtung verschwenkt. Durch diese Bewegung werden die beiden Schwenkhebel 21, 21' nach aussen, d.h. beide von der Mitte weg bewegt und schieben mittels der Stangen 48 und der Verbindungslaschen 49 die Rollenleisten 4, 4' von den Seitenkanten der Druckplatte 33 weg.

Die Druckplatte 33 liegt dann frei und angesaugt auf dem Belichtungstisch 1 auf, und der Belichtungsvorgang kann beginnen.

Nach Beendigung des Belichtungsvorgangs sperrt das Magnetventil 52 die Druckluftzufuhr in der Druckleitung 53 zu den Hubzylindern 8, und die Rückstellfedern 51 bringen die Rollenleisten 4, 4' in ihre Ausgangsstellungen zurück. Gleichzeitig werden die Rollen 10, 10', 10'', ..., durch die Antriebsrollen 11 angetrieben und die belichtete Druckplatte 33 zu der Entwicklungsvorrichtung 44 transportiert. Die ersten Transportrollen 10 der Rollenleisten 4, 4' werden mittels der Schwenkblöcke 5 nach aussen geklappt, so dass noch während des Transportes der belichteten Druckplatte 33 zu der Entwicklungsvorrichtung 44 eine neue unbelichtete Druckplatte 33 aufgenommen werden kann.

Wie aus Fig. 3 ersichtlich ist, sind die beiden Hubzylinder 8 und die beiden Schwenkhebel 21, 21' jedes zu einem Hubzylinder gehörenden Drehgestänges parallel zueinander und symmetrisch zu einer zu den Rollenleisten 4, 4' senkrecht verlaufenden Mittellinie M angeordnet. Zur Verschiebung der Rollenleisten 4, 4' parallel zu ihrer Ausgangs- bzw. Ruhestellung, in der die Rollen an den Seitenkanten der Druckplatte 33 anliegen, ist in jeder Verbindungslasche 49 ein Schlitz 57 vorgesehen, um eine parallele Lage der Rollenleisten 4, 4' vornehmen zu können. Die Führungsstifte 14 sind auf jeder Rollenleiste 4, 4' befestigt und durchsetzen die Schlitze 26. Bei jeder Druckbeaufschlagung der Hubzylinder 8 gleiten dann die Führungsstifte 14 durch die Drehbewegung der mit den Hubzylindern 8 verbundenen Drehgestänge in den Schlitzen 26 und verschieben die Rollenleisten 4, 4' parallel zu sich selbst.

Es ist selbstverständlich für den Fachmann, dass auch mehr als zwei Hubzylinder 8 für die Verstellung der Rollenleisten 4, 4' vorgesehen werden können.

**Patentansprüche**

1. Einzugs- und Transportvorrichtung für Druckformen, die auf einen Belichtungstisch mit Hilfe von Rollen transportierbar sind, mit zu beiden Seitenkanten der Druckform angeordneten Rollen, von denen die in Transportrichtung der Druckform zuerst liegenden Rollen nach aussen schwenkbar sind, dadurch gekennzeichnet, dass die Rollen (10, 10', 10'', ..., 11) drehbar auf Blöcken (5, 6) gelagert sind, die auf zwei zueinander parallelen und beweglichen Rollenleisten (4, 4') befestigt sind, und dass Mittel vorgesehen sind, um vor der Belichtung die Rollenleisten (4, 4') senkrecht zu den Seitenkanten der Druckform (33) nach aussen hin in eine Position parallel zu den Seitenkanten zu verschieben.

2. Einzugs- und Transportvorrichtung nach Anspruch 1, dadurch gekennzeichnet, dass für das Verschieben der Rollenleisten (4, 4') zumindest zwei Hubzylinder (8) unterhalb einer Saugplatte (2) des Belichtungstisches (1) angeordnet sind und dass jeder Hubzylinder (8) über ein Drehgestänge (16, 18, 21, 21', 48, 50) mit jeder der Rollenleisten (4, 4') verbunden ist.

3. Einzugs- und Transportvorrichtung nach Anspruch 2, dadurch gekennzeichnet, dass jeder der Hubzylinder (8) in einer Halterung (15) auf einem feststehenden Gussteil des Belichtungstisches (1) montiert ist.

4. Einzugs- und Transportvorrichtung nach Anspruch 2, dadurch gekennzeichnet, dass das Drehgestänge aus einem Anschlussstück (16), das mit einer Kolbenstange (17) des Hubzylinders (8) verbunden ist, einer Schwenklasche (18) mit zwei Anlenkpunkten (19, 20), zwei Schwenkhebeln (21, 21') mit zugehörigen Klemmstücken (50) und Stangen (48) zum Verbinden der Schwenkhebel (21, 21') über Verbindungslaschen (49) mit den Rollenleisten (4, 4'), besteht.

5. Einzugs- und Transportvorrichtung nach Anspruch 4, dadurch gekennzeichnet, dass die Schwenkhebel (21, 21') mit dem einen Ende drehbar in den Anlenkpunkten (19, 20) der Schwenklasche (18), die geradlinig ausgebildet ist, gelagert sind und dass das andere Ende jedes Schwenkhebels an dem zugehörigen Klemmstück (50) befestigt ist.

6. Einzugs- und Transportvorrichtung nach Anspruch 5, dadurch gekennzeichnet, dass die Schwenklasche (18) mittig in einer Zentralhülse (46) geführt und um diese verschwenkbar ist und dass die Zentralhülse (46) auf einer Zentralbefestigung (47) montiert ist.

7. Einzugs- und Transportvorrichtung nach Anspruch 5, dadurch gekennzeichnet, dass jeder Schwenkhebel (21, 21') aus zwei parallelen, zueinander um die Länge eines Verbindungsstückes (54, 54') versetzten, geradlinigen Stücken (58, 58') besteht und dass das Verbindungsstück (54, 54') bogenförmig an die geradlinigen Stücke (58, 58') anschliesst.

8. Einzugs- und Transportvorrichtung nach Anspruch 4, dadurch gekennzeichnet, dass jedes Drehgestänge mit einer Rückstellfeder (51) ausgestattet ist, die mit dem einen Ende an einem Befestigungspunkt (55) auf dem einen Schwenkhebel (21') und mit dem anderen Ende an einem weiteren Befestigungspunkt (56) auf dem Klemmstück (50) des anderen Schwenkhebels (21) befestigt ist.

9. Einzugs- und Transportvorrichtung nach Anspruch 4, dadurch gekennzeichnet, dass ein Führungsstift (14) auf jeder Rollenleiste (4, 4') befestigt ist und die Schlitze (26) in einem Führungsteil (25) durchsetzt.

10. Einzugs- und Transportvorrichtung nach Anspruch 4, dadurch gekennzeichnet, dass die Hubzylinder (8) und die zwei Schwenkhebel (21, 21') jedes zugehörigen Drehgestänges parallel zueinander und symmetrisch zu einer zu den Rollenleisten (4, 4') senkrecht verlaufenden Mittellinie (M) angeordnet sind.

11. Einzugs- und Transportvorrichtung nach Anspruch 9, dadurch gekennzeichnet, dass die Hubzylinder (8) eine gemeinsame Druckleitung (53) verbindet, in der ein Magnetventil (52) angeordnet ist, das von Signalen eines Signalgebers (23) gesteuert wird.

12. Einzugs- und Transportvorrichtung nach Anspruch 4, dadurch gekennzeichnet, dass die Stangen (48) innerhalb der festliegenden Klemmstücke (50) verschiebbar und so festlegbar sind, dass der gegenseitige Abstand der Rollenleisten (4, 4') unterschiedlichen Druckplattenbreiten angepasst werden kann.

## Claims

1. Device for feeding in and transporting printing forms which can be transported onto an exposure table with the aid of rollers, this device having rollers which are arranged at the two lateral edges of the printing form, of which rollers those positioned first, in the transport direction of the printing form, can be pivoted outwards, characterised in that the rollers (10, 10', 10'', ..., 11) are rotatably mounted on blocks (5, 6) which are fastened on two roller rails (4, 4') which are parallel, one to the other, and are movable, and in that means are provided to shift outwards the roller rails (4, 4'), before the exposure perpendicularly to the lateral edges of the printing forms (33), into a position parallel to the lateral edges.

2. Feeding-in and transporting device as claimed in Claim 1, characterised in that, for shifting the roller rails (4, 4'), two or more lifting cylinders (8) are located beneath a suction plate (2) of the exposure table (1), and in that each lifting cylinder (8) is connected, via a rotary lever system (16, 18, 21, 21', 48, 50), to each of the roller rails (4, 4').

3. Feeding-in and transporting device as claimed in Claim 2, characterised in that each of the lifting cylinders (8) is installed in a retaining device (15) on a stationary cast component of the exposure table (1).

4. Feeding-in and transporting device as claimed in Claim 2, characterised in that the rotary lever system comprises a connecting piece (16), which is connected to a piston rod (17) of the lifting cylinder (8), a pivoting link (18) with two coupling points (19, 20), two pivoting levers (21, 21') with associated clamping pieces (50) and rods (48) for connecting the pivoting levers (21, 21') to the roller rails (4, 4') via connecting links (49).

5. Feeding-in and transporting device as claimed in Claim 4, characterised in that the pivoting levers (21, 21') are mounted with the one end capable of rotation in the connecting points (19, 20) of the pivoting link (18) which is designed as a straight-line link, and in that the other end of each pivoting lever is fastened to the associated clamping piece (50).

6. Feeding-in and transporting device as claimed in Claim 5, characterised in that the pivoting link (18) is guided, at its mid-point, in a central sleeve (46) and can be pivoted about this sleeve, and in that the central sleeve (46) is installed on a central fixture (47).

7. Feeding-in and transporting device as claimed in Claim 5, characterised in that each pivoting lever (21, 21') comprises two parallel straight-line sections (58, 58') which are offset with respect to each other by the length of a connecting section (54, 54'), and in that the connecting section (54, 54') is joined to the straight-line sections (58, 58') in an arcuate manner.

8. Feeding-in and transporting device according to Claim 4, characterised in that each rotary lever system is fitted with a return spring (51), one end of which is fastened to an attachment point (55) on the one pivoting lever (21'), and the other end of which is fastened to a further attachment point (56) on the clamping piece (50) of the other pivoting lever (21).

9. Feeding-in and transporting device as claimed in Claim 4, characterised in that a guide pin (14) is fastened on each roller rail (4, 4') and passes through slots (26) in a feeding piece (25).

10. Feeding-in and transporting device as claimed in Claim 4, characterised in that the lifting cylinders (8) and the two pivoting levers (21, 21') of each associated rotary lever system are located parallel to each other and symmetrically with respect to a center-line (M) running perpendicularly to the roller rails (4, 4').

11. Feeding-in and transporting device as claimed in Claim 9, characterised in that the lifting cylinders (8) are connected by a common pressure line (53), in which a magnetic valve (52) is located, this valve being controlled by signals from a signal transmitter (23).

12. Feeding-in and transporting device as claimed in Claim 4, characterised in that the rods (48) can be shifted inside the immovable clamping pieces (50) and fixed in a manner such that the distance between the roller rails (4, 4') can be matched to different printing-plate widths.

## Revendications

1. Dispositif d'introduction et de transport pour formes d'impression qui peuvent être amenées à une table d'insolation au moyen de rouleaux, comprenant des rouleaux disposés sur les deux bords latéraux de la forme d'impression, dont les rouleaux qui se trouvent en premier rang dans le sens du transport de la forme d'impression peuvent être écartés vers l'extérieur par pivotement, caractérisé en ce que les rouleaux (10, 10', 10'', ..., 11) sont montés rotatifs sur des blocs (5, 6) qui sont fixés sur deux barres à rouleaux (4, 4') parallèles et mobiles, et en ce qu'il est prévu des moyens pour déplacer les barres à rouleaux (4, 4') avant l'insolation, perpendiculairement aux bords latéraux de la plaque d'impression (33), vers l'extérieur, pour les amener dans une position parallèle aux bords latéraux.

2. Dispositif d'introduction et de transport selon la revendication 1, caractérisé en ce que, pour le déplacement des barres à rouleaux (4, 4'), au moins deux vérins (8) sont disposés au-dessous d'une plaque aspirante (2) de la table d'insolation (1) et en ce que chaque vérin (8) est relié par une tringlerie tournante (16, 18, 21, 21', 48, 50) à chacune des deux barres à rouleaux (4, 4').

3. Dispositif d'introduction et de transport selon la revendication 2, caractérisé en ce que chacun des vérins (8) est monté dans une monture (15) sur une pièce de fonderie fixe de la table d'insolation (1).

4. Dispositif d'introduction et de transport selon la revendication 2, caractérisé en ce que la tringlerie tournante est composée d'une pièce de raccordement (16) qui est reliée à une tige de piston (17) du vérin (8), d'une barre pivotante (18) munie de deux points d'articulation (19, 20), de deux leviers oscillants (21, 21') munis de pièces de serrage correspondantes (50) et de tiges (48) destinées à relier les leviers oscillants (21, 21') aux barres à rouleaux (4, 4') par l'intermédiaire de pattes de liaison (49).

5. Dispositif d'introduction et de transport selon la revendication 4, caractérisé en ce que les leviers oscillants (21, 21') sont montés rotatifs, par une première extrémité, sur les points d'articulation (19, 20) de la barre pivotante (18) qui est de configuration rectiligne, et en ce que l'autre extrémité de chaque levier oscillant est fixé à la pièce de serrage correspondante (50).

6. Dispositif d'introduction et de transport selon la revendication 5, caractérisé en ce que la barre pivotante (18) est guidée en son centre dans un manchon central (46) et peut pivoter autour de ce dernier et en ce que le manchon central (46) est monté sur une fixation centrale (47).

7. Dispositif d'introduction et de transport selon la revendication 5, caractérisé en ce que chaque levier oscillant (21, 21') est composé de deux éléments (58, 58') rectilignes, parallèles, déportés l'un par rapport à l'autre de la longueur d'un élément de liaison (54, 54') et en ce que l'élément de liaison (54, 54') se raccorde en arc aux éléments rectilignes (58, 58').

8. Dispositif d'introduction et de transport selon la revendication 4, caractérisé en ce que chaque tringlerie tournante est équipée d'un ressort de rappel (51) qui est fixé, par l'une de ses extrémités, en un point de fixation (55), sur un premier levier oscillant (21') et, par son autre extrémité, en un autre point de fixation (56), sur la pièce de serrage (50) de l'autre levier oscillant (21).

9. Dispositif d'introduction et de transport selon la revendication 4, caractérisé en ce qu'un doigt de guidage (14) est fixé sur chaque barre à rouleaux (4, 4') et traverse les fentes (26) d'un élément de guidage (25).

10. Dispositif d'introduction et de transport selon la revendication 4, caractérisé en ce que les vérins (8) et les deux leviers oscillants (21, 21') de chaque tringlerie tournante correspondante sont disposés parallèlement l'un à l'autre et symétriquement par rapport à un axe (M) qui s'étend perpendiculairement aux barres à rouleaux (4, 4').

11. Dispositif d'introduction et de transport selon la revendication 9, caractérisé en ce que les vérins (8) sont reliés à une conduite de pression commune (53) dans laquelle est interposée un distributeur électromagnétique (52) qui est commandé par des signaux d'un émetteur de signaux (23).

12. Dispositif d'introduction et de transport selon la revendication 4, caractérisé en ce que les tiges (48) sont montées pour pouvoir coulisser à l'intérieur des pièces de serrage fixes (50) et à pouvoir y être bloquées, de manière que la distance d'écartement entre les barres à rouleaux (4, 4') puisse être adaptée à différentes largeurs de plaques d'impression.

FIG.1

FIG.2

0 066 789

# FIG. 3

0 066 789

FIG.4